# FASCICULE DE BREVET EUROPEEN

(11) **EP 3 672 382 B1**
(45) Date de publication et mention de la délivrance du brevet: **03.08.2022**
(21) Numéro de dépôt: 19213473.2
(22) Date de dépôt: 04.12.2019
(51) Int. Cl.: H05K 7/20

(54) **ORGANE DE PLAQUAGE, ENSEMBLE ET EQUIPEMENT ELECTRIQUE**
PRESSELEMENT, MONTAGE UND ELEKTRISCHE AUSRÜSTUNG
PRESSING ELEMENT, ASSEMBLY AND ELECTRICAL EQUIPMENT

(30) Priorité: 21.12.2018 FR 1873801
(43) Date de publication de la demande: 24.06.2020
(73) Titulaire: Valeo Siemens eAutomotive France SAS, 95800 Cergy (FR)
(72) Inventeur: LEGENDRE, Alexandre, 95280 Jouy-le-Moutier (FR); POUILLY, Aurélien, 78300 Poissy (FR)

(56) Documents cités:
- EP-A1- 3 197 035
- WO-A1-2014/033382
- DE-A1- 10 142 987
- JP-A- 2000 223 630
- JP-A- 2005 116 650

## Description

### DOMAINE TECHNIQUE ET OBJET DE L'INVENTION

La présente invention concerne un organe de plaquage, un ensemble comportant un tel organe de plaquage et un dispositif électronique, et un équipement électrique comprenant un tel ensemble, par exemple embarqué dans un véhicule automobile. Un tel équipement électrique peut être un onduleur, un convertisseur de tension ou un chargeur électrique de batterie.

### ÉTAT DE LA TECHNIQUE

Typiquement, dans des applications de véhicule électrique ou hybride, les équipements électriques, utilisés notamment pour la traction du véhicule, peuvent, au cours du fonctionnement du véhicule, présenter des tensions élevées, par exemple compris entre 200V et 800V. De tels équipements électriques comprennent par exemple un onduleur, un convertisseur de tension ou un chargeur électrique embarqué. La génération de chaleur par effet joule dans les composants électroniques de ces équipements peut alors devenir importante au risque d'endommager le composant électronique. Afin d'éviter toute dégradation par la chaleur, un système de refroidissement des composants électroniques est nécessaire. Il est connu d'utiliser un organe de plaquage pour plaquer le composant électronique contre une surface du système de refroidissement pour améliorer son refroidissement. On connaît un tel organe de plaquage 11, illustré en figure 1, par la publication de demande de brevet WO2014033382. L'organe de plaquage 11 vient contre un module électronique de puissance 30 pour le plaquer contre une surface d'un système de refroidissement de l'équipement électrique. L'organe de plaquage 11 comprend une portion en forme de plaque 12 qui comporte des ouvertures 14 depuis lesquelles des lames ressort 16 s'étendent. Dans chaque ouverture 14 s'étend une lame 16 ou deux lames 16 situées en vis-à-vis. Pour assurer un plaquage efficace du composant électronique 30, la plaque ressort exerce typiquement un effort de 100kg sur le composant électronique 30 par l'intermédiaire des lames ressort 16. Chaque lame ressort 16 doit donc exercer un effort de 12,5kg sur le composant 30. Or cet effort exercé par une lame 16 peut endommager la surface du composant 30, par exemple une couche superficielle du composant 30. Pour palier cela, il est connu d'introduire une seconde plaque intercalée entre le composant électronique 30 et la plaque ressort 10. Cependant cette plaque supplémentaire augmente la hauteur de l'ensemble et complexifie son assemblage.

Il est donc recherché un système de plaquage des composants électroniques permettant de limiter un dommage de la surface du composant électronique de manière simple et efficace.

### PRÉSENTATION GÉNÉRALE DE L'INVENTION

À cet effet, la présente invention concerne un organe de plaquage comprenant une portion en forme de plaque et une pluralité de lames ressort, chaque lame ressort ayant une première extrémité intégrale avec la portion en forme de plaque et une deuxième extrémité distale par rapport à la première extrémité destinée à venir en appui contre un corps sur lequel l'organe de plaquage exerce un effort. Dans l'organe de plaquage selon l'invention, la portion en forme de plaque comprend au moins une première ouverture traversante dont les bords sont intégralement formés par ladite pluralité de lames ressort.

Ainsi, contrairement à l'art antérieur, tous les bords de l'ouverture traversante comprennent une lame ressort, ce qui permet d'augmenter la quantité de lames ressort de l'organe de plaquage par rapport à l'organe de plaquage de l'art antérieur. Ainsi, l'effort de plaquage sur le corps est mieux réparti entre les lames ressort, ce qui permet d'éviter un endommagement de la surface du composant électronique.

Selon un mode de réalisation, les lames ressort sont formées par une succession d'arc concaves et convexes, notamment définis dans ladite portion en forme de plaque.

Selon un mode de réalisation, les deuxièmes extrémités des lames ressort définissent une zone libre centrale autour de laquelle elles sont régulièrement réparties.

Selon un mode de réalisation, l'organe de plaquage comprend une pluralité de ladite première ouverture traversante, dont les bords de chacune sont intégralement formés par une pluralité de lames ressort.

Selon un mode de réalisation, l'organe de plaquage comprend au moins une seconde ouverture traversante, dont les bords comprennent des lames ressort.

Selon une variante, ladite au moins une seconde ouverture traversante est située dans la portion en forme de plaque entre lesdites premières ouvertures.

Selon une variante particulière, les premières ouvertures sont agencées de sorte à être aux sommets d'un quadrilatère, l'au moins une deuxième ouverture étant située dans une zone médiane dudit quadrilatère.

L'invention concerne également un ensemble comprenant un dispositif électrique et au moins un organe de plaquage selon l'invention, ensemble dans lequel :
- ledit dispositif électrique comprend au moins un composant électronique et au moins un conducteur électrique fixé sur ledit composant électronique pour le connecter électriquement, ledit composant électronique et ledit conducteur électrique étant connectés l'un à l'autre au niveau d'une zone, dite zone de fixation,
- l'organe de plaquage est configuré pour plaquer ledit dispositif électrique contre une surface, en venant contre une face, dit face de plaquage, dudit dispositif électrique comprenant ladite zone de fixation ,
ladite zone de fixation venant dans la première ouverture de l'organe de plaquage lors du plaquage dudit dispositif électrique par l'organe de plaquage.

Selon un mode de réalisation, ladite face de plaquage comprend deux zones de fixation à distance l'une de l'autre et l'organe de plaquage comprend deux premières ouvertures à distance l'une de l'autre de manière à entourer chacune une zone de fixation, une seconde ouverture traversante étant située à équidistance entre lesdites premières ouvertures.

Selon un mode de réalisation, la face de plaquage dudit dispositif électrique comprend une polarité positive et une polarité négative dudit dispositif électrique.

Selon un mode de réalisation, au moins une feuille d'isolation électrique est intercalée entre l'organe de plaquage et la face de plaquage.

Selon un mode de réalisation, ledit dispositif électrique comporte :
- au moins deux composants électroniques, tels qu'une première partie de la face de plaquage comprend une borne positive d'un premier composant électronique et une deuxième partie de la face de plaquage comprend une borne négative d'un deuxième composant électronique,
- un premier conducteur électrique, connecté à la borne positive du premier composant électronique et un deuxième conducteur électrique connecté à la borne négative du deuxième composant électronique, le premier et le deuxième conducteur électrique comportant chacun un bras s'étendant entre le premier et le deuxième composant électronique pour se connecter respectivement à une borne positive du deuxième composant électronique et à une borne négative du premier composant électronique, lesdits bras étant agencés l'un à côté de l'autre l'ensemble comprenant une première feuille d'isolation électrique intercalée entre l'organe de plaquage et la première partie de la face de plaquage et une deuxième feuille d'isolation électrique intercalée entre l'organe de plaquage et la deuxième partie de la face de plaquage, la première et la deuxième feuille d'isolation électrique s'étendant respectivement le long du bras du deuxième conducteur électrique et du bras du premier conducteur électrique.de manière à isoler électriquement les conducteurs électriques entre eux.

Selon un mode de réalisation, l'ensemble comprend deux organes de plaquage, chaque organe de plaquage étant directement en contact avec une polarité respective, lesdits organes de plaquage étant isolés électriquement l'un de l'autre.

Selon un mode de réalisation, le dispositif électrique est un bloc capacitif et les composants électroniques sont des condensateurs.

L'invention concerne en outre un équipement électrique comprenant un châssis et un ensemble selon l'invention, dans lequel ledit organe de plaquage est pris en compression entre une surface dudit châssis et le dispositif électrique, de manière à plaquer le dispositif électrique contre un circuit de refroidissement de l'équipement électrique.

### PRÉSENTATION DES FIGURES

L'invention sera mieux comprise et d'autres détails, caractéristiques et avantages de l'invention apparaîtront à la lecture de la description suivante faite à titre d'exemple non limitatif en référence aux figures annexées dans lesquelles :
Fig. 1, déjà décrite, présente un organe de plaquage de l'art antérieur ;
Fig. 2 présente un organe de plaquage selon un exemple de l'invention ;
Fig. 3 présente une vue agrandie de l'organe de plaquage de la figure 2 ;
Fig. 4 présente un ensemble selon un exemple de l'invention ;
Fig. 5 présente un dispositif électrique d'un ensemble selon un exemple de l'invention ;
Fig. 6 présente un dispositif électrique d'un ensemble selon un exemple de l'invention ;
Fig. 7 présente une vue de dessus d'un ensemble selon un exemple de l'invention ;
Fig. 8 présente un organe de plaquage selon un exemple de l'invention ;
Fig. 9 présente un équipement électrique selon un exemple de l'invention.

### DESCRIPTION DETAILLEE DE L'INVENTION

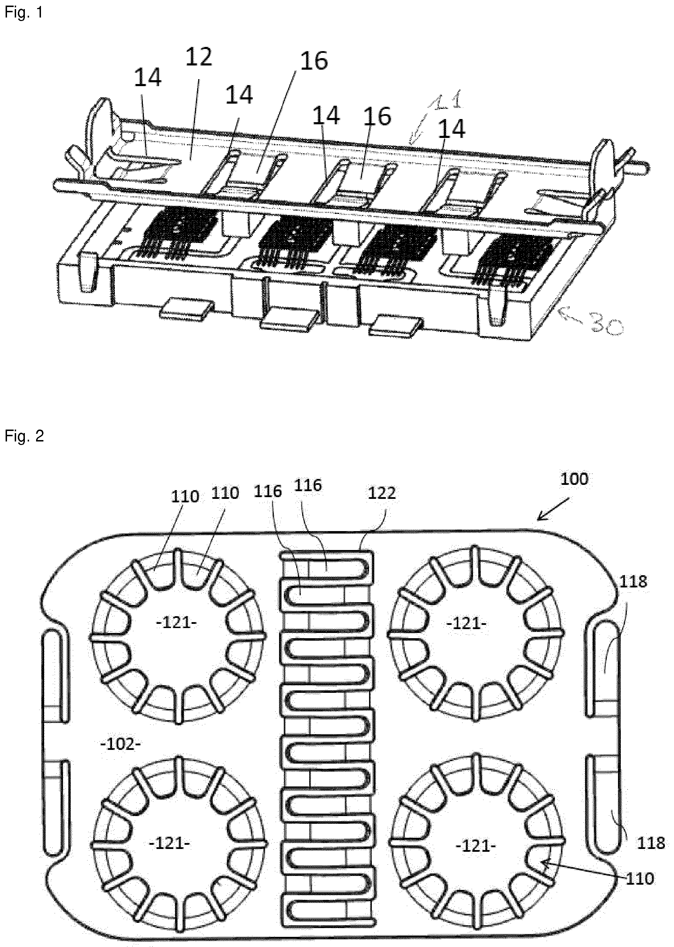

Un exemple d'organe de plaquage 100 va être décrit en faisant référence aux figures 2 à 4. L'organe de plaquage 100 comprend une portion 102 en forme de plaque et plusieurs lames ressort 110. Chaque lame ressort 110 présente une première extrémité 111 qui est intégrale avec la portion en forme de plaque 102. Une deuxième extrémité 112 de la lame ressort 110 est distale par rapport à la première extrémité 111 et est destinée à venir en appui contre un corps 150 sur lequel l'organe de plaquage 100 exerce un effort. La portion en forme de plaque 102 comprend une première ouverture traversante 121 dont les bords sont intégralement formés par les lames ressort 110. Ainsi les lames ressort 110 sont juxtaposées l'une à côté de l'autre tout le long du bord de l'ouverture 121. Dans l'art antérieur illustré en figure 1, les lames ressort 16 sont reliées par une portion droite du bord de l'ouverture 14. Deux lames ressort 16 sont à distance l'une de l'autre. Dans l'organe de plaquage 100, les bords de l'ouverture traversante 121 sont complètement définis par les lames ressort 110. Ainsi, l'ouverture traversante 121 comprend plus de lames ressort par rapport à l'art antérieur. Ce qui permet de diminuer l'effort individuel exercé par une lame ressort et ainsi, de préserver la surface du corps 150 plaqué par l'organe de plaquage 100.

En particulier, les lames ressort 110 sont définies par une succession d'arcs convexes 113 et d'arcs concaves 114. Ces arcs 113, 114 sont par exemple définis dans la portion 102 en forme de plaque. Notamment, l'ensemble des deuxièmes extrémités 112 des lames ressort 110 définissent une zone libre centrale 121a autour de laquelle elles sont régulièrement réparties. Par exemple, la portion 102 en forme de plaque subit une découpe par laquelle on enlève de la matière pour définir la partie centrale 121a de l'ouverture 121, les lames ressort 11 étant formées tout autour de cette zone centrale 121a par la définition des arcs convexes 113 et concaves 114. La zone libre centrale 121a permet notamment de laisser une portion de la face du corps 150 libre de tout appui comme cela sera expliqué plus loin. Les lames ressort 110 s'étendent radialement depuis la zone libre centrale 121a depuis leur deuxième extrémité 112 vers leur première extrémité 111. Une fois montées sur le corps 150, les deuxièmes extrémités 112 appuient tout autour de la zone libre centrale 121a, permettant ainsi un appui au plus de la zone libre centrale 121a.

Plusieurs premières ouvertures traversantes 121 peuvent être régulièrement réparties dans la portion en forme de plaque 102, notamment pour permettre un appui autour de plusieurs zones libres centrales 121a.

Selon une variante, l'organe de plaquage 100 comprend une seconde ouverture traversante 122, dont les bords comprennent des lames ressort 116. Ces lames ressort 116 peuvent être agencées en quinconce, de sorte que dans une vue de dessus, par exemple comme en figure 2, la seconde ouverture 122 forme dans la portion en forme de plaque 102 une boucle alternativement concave et convexe suivant une direction. Cette seconde ouverture 122 complète l'effort de plaquage exercé par les lames ressort 110 des premières ouvertures 121. En particulier, la seconde ouverture traversante 122 est située entre les premières ouvertures. 121, afin de permettre un plaquage entre les premières ouvertures 121.

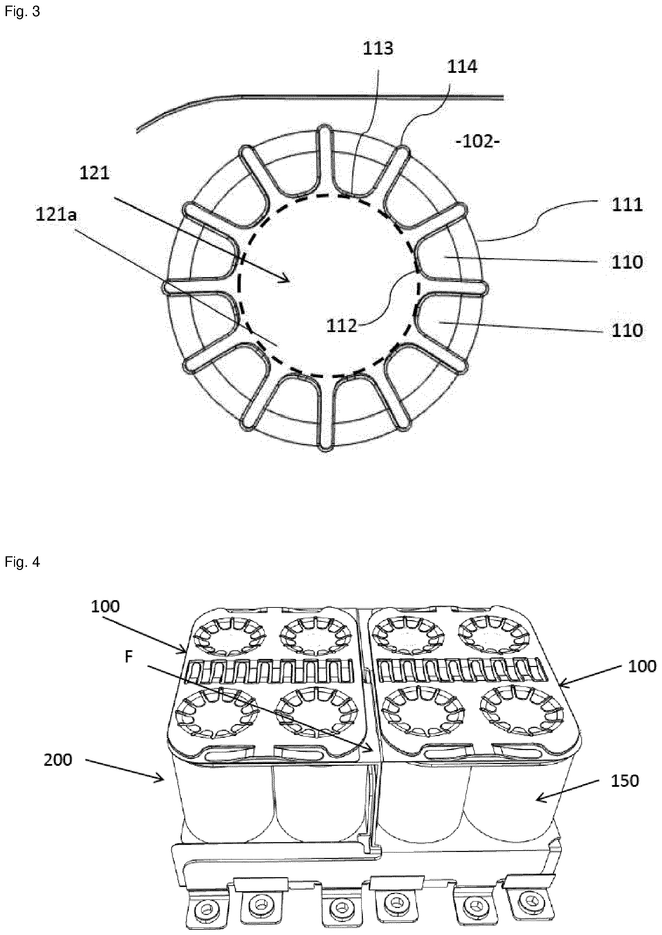

Comme illustré sur les figures, les premières ouvertures 121 peuvent être réparties sur les sommets d'un quadrilatère. La seconde ouverture 122 est alors par exemple située dans une zone médiane dudit quadrilatère. Cette configuration peut être particulièrement avantageuse lorsque l'organe de plaquage 100 plaque un dispositif électrique 150 tel qu'illustré en figure 4 à 6, qui sera décrit plus loin.

L'organe de plaquage 100 peut comprendre en outre des lames ressort 118 situées en périphérie de la portion 102 en forme de plaque. Ces lames ressort 118 sont par exemple situées sur un bord de la portion 102 en forme de plaque. Notamment, les lames ressort 118 s'étendent depuis la portion en forme de plaque 102 en s'éloignant l'une de l'autre le long d'une direction. Ces lames 118 situées en périphérie contribuent également à l'effort exercé par l'organe de plaquage sur le corps 150.

Globalement, l'ensemble des lames ressort 110, 116, 118 sont réparties sur la portion 102 en forme de plaque afin de laisser libre de tout appui des zones du corps 150 et de multiplier les zones d'appui sur le corps 150.

Par exemple, l'organe de plaquage 100 est obtenu à partir d'une plaque découpée. Grâce à son nombre de lames ressort plus élevé que dans l'art antérieur, l'organe de plaquage 100 peut être formé dans une plaque ayant une épaisseur plus faible. Par exemple, l'épaisseur de la plaque est comprise entre 0,4 et 0,5 mm alors que dans l'art antérieur l'épaisseur de la plaque est comprise entre 0,8 et 1mm. Ainsi, l'épaisseur de la plaque à partir de laquelle l'organe de plaquage 100 est obtenue peut être divisée par 2.

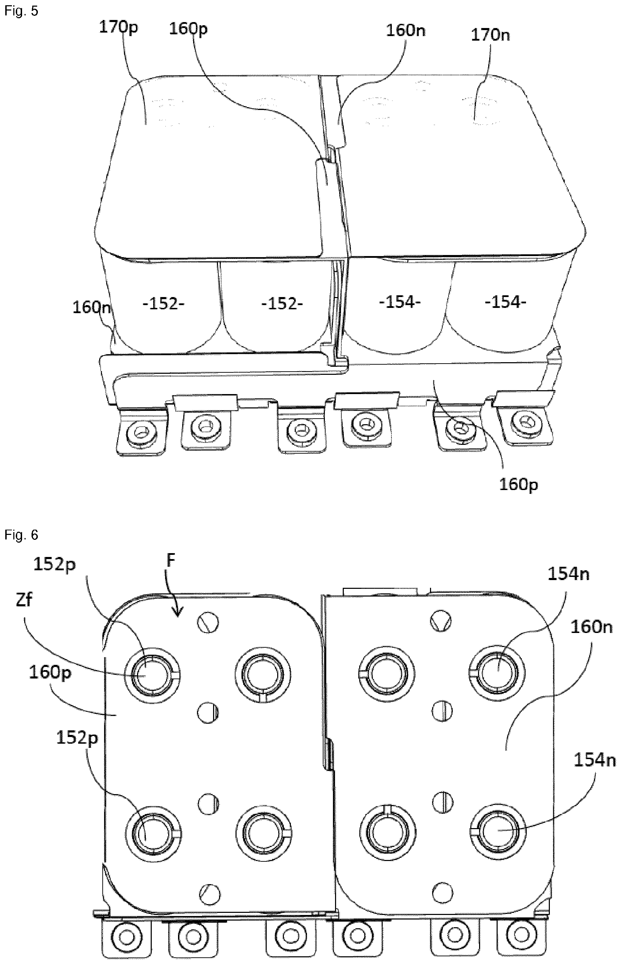

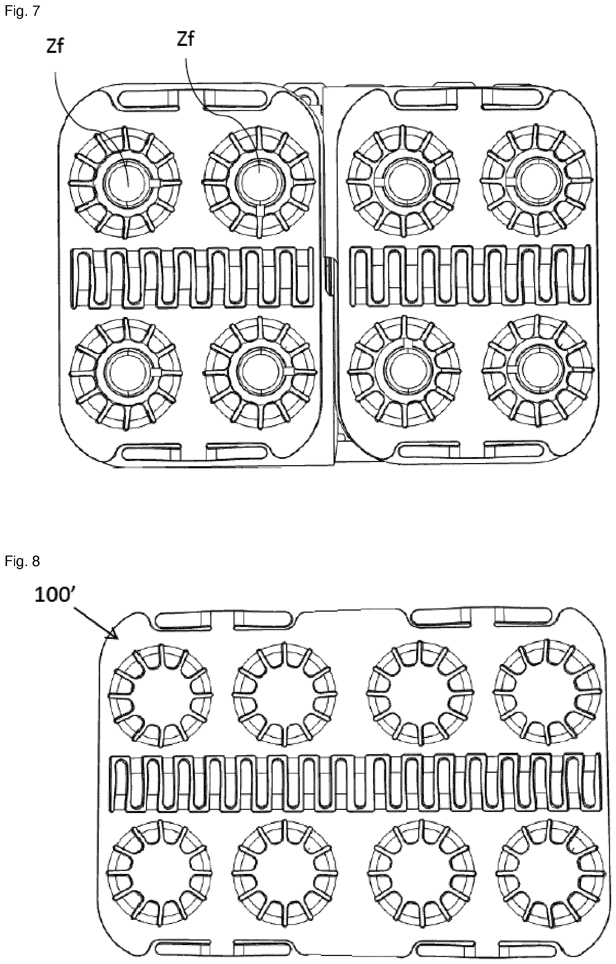

La figure 4 illustre un ensemble 200 selon un exemple de l'invention. L'ensemble 200 comprend un dispositif électrique 150 par exemple tel qu'illustré en figure 5. Le dispositif électrique 150 comprend des composant électroniques 152,154. Des conducteurs électriques 160p, 160n sont fixés sur les composants électroniques 152,154 pour les connecter électriquement. Les composants électroniques 152,154 et les conducteurs électriques 160p, 160n sont connectés l'un à l'autre au niveau de zones Zf, dites zones de fixation, visibles en figures 6 ou 7. Ces zones de fixation Zf peuvent présenter une hauteur variable d'une zone à l'autre. C'est en particulier le cas lorsque les conducteurs 160p, 160n sont soudés par soudage sur des bornes des composants électroniques 152,154. L'épaisseur des soudures au niveau des zones de fixation Zf peut varier d'une zone de fixation Zf à l'autre. Ces zones de fixation Zf peuvent en outre former des excroissances par rapport au reste de la portion 102 en forme de plaque.

L'organe de plaquage 100 est positionné sur une face F, dite face de plaquage, du dispositif électrique 150. En appuyant sur cette face de plaquage F, l'organe de plaquage 100 est configuré pour plaquer le dispositif électrique 150 contre une surface. Cette face de plaquage comprend notamment lesdites zones de fixation Zf.

Dans une solution de l'art antérieur, l'organe de plaquage ne prend pas en compte la variabilté de la hauteur des zones de fixation Zf. Ce faisant, l'organe de plaquage de l'art antérieur peut exercer un effort plus important sur une zone de fixation Zf plus haute que les autres. Cela entraine une usure différenciée entre les zones de fixation. Dans l'ensemble 200 selon un exemple de l'invention, chaque zone de fixation Zf vient dans une première ouverture 121 de l'organe de plaquage 100. Ainsi, l'organe de plaquage 100 n'exerce pas d'effort directement sur les zone de fixation Zf, et évite de la sorte une usure différenciée de ces zones de fixation Zf. En outre, lorsque ces zones de fixation Zf forment des excroissances par rapport au reste de la portion 102 en forme de plaque, cela permet d'éviter un effort trop important sur ces zones de fixation Zf par rapport au reste de la portion 102 en forme de plaque. Les deuxièmes extrémités 122 des lames ressort 110 viennent tout autour de la zone de fixation Zf, pour notamment répartir régulièrement l'effort de plaquage autour la zone de fixation Zf respective.

Chaque composant électronique 152, 154 peut comprendre deux bornes 152p, 154n de même polarité dans un même plan, comme par exemple illustré en figure 6. Les bornes 152p, 154n d'un composant électronique 152, 154 sont à distance l'une de l'autre. Ainsi, notamment sur la face de plaquage F, les deux zones de fixation Zf correspondantes sont à distance l'une de l'autre, par exemple comme illustré sur les figures. Dans cette configuration, l'organe de plaquage 100 comprend deux premières ouvertures 121 à distance l'une de l'autre qui viennent entourer chacune une zone de fixation Zf respective. La seconde ouverture traversante 122 est située à équidistance entre les premières ouvertures 121. Ainsi, la seconde ouverture 122 vient appuyer sur une partie médiane d'un composant électronique 152, 154 de manière à améliorer le plaquage du composant électronique 152, 154. Les composants électroniques 152, 154 sont notamment arrangés en ligne l'un à côté de l'autre, de sorte que l'ensemble des bornes électriques sont réparties sur deux plans parallèles qui sont en vis-à-vis. Sur les figures, les bornes 154p, 154n situées dans un de ces plans sont représentés.

La face de plaquage F peut comprendre une polarité positive et une polarité négative du dispositif électrique 150. Par exemple, les composants électroniques 152 d'un premier côté de la rangée de composants électronique sont tête-bêche par rapport aux composants électroniques 154 d'un deuxième côté de la rangée. Ainsi, vu de la face de plaquage F, le premier côté de la rangée comprend des bornes de polarité opposée à celle des bornes du deuxième côté de la rangée de composants électroniques 152, 154.

Une feuille d'isolation électrique 170p, 170n est notamment intercalée entre l'organe de plaquage 100 et la face de plaquage F afin d'isoler l'organe de plaquage 100 du dispositif électrique 150. Dans l'art antérieur, une plaque d'isolation suffisamment épaisse est nécessaire pour protéger la face de plaquage F de l'effort exercé par les lames ressort. Dans l'ensemble 200 selon l'exemple de l'invention, les lames ressort 110, 116 exercent chacune un effort inférieur par rapport à l'art antérieur, ce qui permet d'utiliser une feuille d'isolation électrique au lieu d'une plaque. Une telle feuille est souple alors que la plaque d'isolation est rigide. Par exemple, la feuille d'isolation électrique a une épaisseur de 0,5mm et est notamment en polyuréthane. Alors que dans l'art antérieur la plaque d'isolation électrique a une épaisseur de 2mm et est notamment en un composite résiné epoxy.

L'ensemble 200 comprend une feuille d'isolation électrique en particulier lorsqu'un seul organe de plaquage 100' est utilisé pour plaquer le dispositif électrique 150. L'organe de plaquage est par exemple tel que celui illustré en figure 8. L'organe de plaquage 100' est par ailleurs similaire à l'organe de plaquage 100 illustré sur les autres figures et est utilisé de la même manière. Cependant, une ou plusieurs feuilles d'isolation électrique170p, 170n peuvent être utilisées dans le cas où deux organes de plaquage 100 sont utilisés pour plaquer le dispositif électrique 150, par exemple comme illustré en figure 4.

En particulier, en figures 4 à 7 une première partie de la face de plaquage F comprend les bornes positives 152p de premiers composants électroniques 152 et une deuxième partie de la face de plaquage F comprend des bornes négatives 154n de deuxièmes composants électroniques 154. La première partie de la face de plaquage F est donc située dans le premier côté de la rangée de composant électroniques, et la deuxième partie de la plaque de plaquage F est située dans le deuxième côté de la rangée de composants électroniques. Un des conducteurs, dit conducteur positif 160p, est connecté aux bornes positives 152p des premiers composants électroniques 152. Un deuxième conducteur électrique, dit conducteur négatif 160n, est connecté aux bornes négatives 154n des deuxièmes composants électroniques 154. Chaque conducteur électrique 160p, 160n comprend un bras qui s'étend entre d'une part les premiers composants électroniques 152 et d'autre part les deuxièmes composants électroniques 154. Ces bras sont agencés l'un à côté de l'autre, les tranches des conducteurs électriques 170, 170n se faisant face. Le bras du conducteur positif 160p se connecte aux bornes positives des deuxièmes composants électroniques 154. Le bras du conducteur négatif 160n se connecte aux bornes négatives des premiers composants électroniques 152. Dans cette configuration, une première feuille d'isolation électrique 170p peut être intercalée entre l'organe de plaquage 100 et la première partie de la face de plaquage F et une deuxième feuille d'isolation électrique 170n peut être intercalée entre l'organe de plaquage100 et la deuxième partie de la face de plaquage F. La première feuille d'isolation électrique 170p peut alors s'étendre le long du bras du conducteur négatif 160n et la deuxième feuille d'isolation électrique 170n peut alors s'étendre le long du bras du conducteur positif 160p.

Ces feuilles d'isolation électriques 170p, 170n contribuent à l'isolation électrique des conducteurs électriques 170p, 170n à l'endroit où ces conducteurs 160p, 160n sont les plus proches, c'est-à-dire entre les premiers 152 et le deuxièmes 154 composants électroniques. Notamment, la première feuille d'isolation électrique 170p assure une isolation électrique entre la portion du conducteur positif 160p comprise dans la face de plaquage F et le bras du conducteur négatif 160n. De même, la deuxième feuille d'isolation électrique 170n assure une isolation électrique entre la portion du conducteur négatif 160n comprise dans la face de plaquage F et le bras du conducteur positif 160p. Les feuilles d'isolation électriques 170n, 170p sont donc intégrées dans le dispositif électronique 150. Pour assurer l'isolation électrique en les organes de plaquage 100 et le dispositif électrique 150, on utilise donc ces feuilles 170n, 170p qui sont déjà prévues pour isoler les conducteurs 160p, 160n entre eux. Ainsi, l'intégration de l'ensemble 200 est amélioré.

Dans la variante de l'ensemble 200 illustrée en figures 4 ou 7, l'ensemble 200 comprend deux organes de plaquages 100. En particulier, dans l'exemple illustré en figure 4 une feuille d'isolation électrique est intercalée entre les organes de plaquage 100 et la face de plaquage F ; dans l'exemple illustré en figure 7, les organes de plaquage 100 viennent directement contre la face de plaquage F du dispositif électrique 150. Chaque organe de plaquage 100 est en contact avec une polarité respective de la face de plaquage F. Les organes de plaquage 100 sont isolés électriquement l'un de l'autre, par exemple par une distance les séparant. Une telle isolation électrique pourrait être obtenu par un matériau isolant intercalé entre eux.

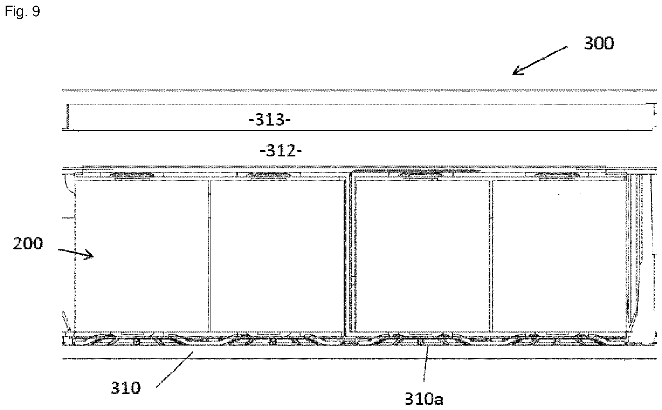

La figure 9 représente un équipement électrique 300 comprenant un ensemble 200 selon un exemple de l'invention. L'ensemble 200 est monté sur un châssis 310 de l'équipement électrique 300. L'organe de plaquage 100 est pris en compression entre une surface 310a dudit châssis 310 et le dispositif électrique 150 de manière à plaquer le dispositif électrique 150 contre un circuit de refroidissement 312 de l'équipement électrique 300. Ce circuit de refroidissement 312 comprend notamment un canal 313 par lequel circule un fluide destiné à drainer la chaleur du dispositif électrique 150. Le circuit de refroidissement 312 vient notamment contre une face du dispositif électrique 150, ladite face étant opposée á la face de plaquage F.

L'équipement électrique 300 est par exemple un onduleur embarqué dans un véhicule et configuré pour alimenter un moteur du véhicule à partir d'une batterie. Alternativement, l'équipement électrique 200 peut être un convertisseur de tension continu-continu configuré pour échanger de l'énergie entre une batterie haute tension et une batterie basse tension du véhicule, ou un chargeur électrique configuré pour charger une batterie haute tension du véhicule depuis un réseau électrique extérieur au véhicule

Dans les figures, le dispositif électrique est notamment un bloc capacitif 150 dans lequel les composants électroniques sont des condensateurs 152, 154. Cependant, le dispositif électrique 150 illustré pourrait comprendre d'autres composants électroniques, par exemple en autres des résistances, ou des bobines inductives.

L'exemple illustré comprend plusieurs composants électroniques 152, 154 et deux conducteurs électriques 160p, 160n fixés sur la face de plaquage F. Cependant, cet exemple pourrait comprendre un seul composant électronique 152, 154 et un seul conducteur électrique 160p, 160n fixé sur la face de plaquage F.

## Revendications

1. Organe de plaquage (100, 100') pour plaquer un dispositif électrique (150) contre une surface, l'organe de plaquage (100, 100') comprenant une portion (102) en forme de plaque et une pluralité de lames ressort (110), chaque lame ressort (110) ayant une première extrémité (111) intégrale avec la portion (102) en forme de plaque et une deuxième extrémité (112) distale par rapport à la première extrémité (111), ladite deuxième extrémité (112) étant destinée à venir en appui contre le dispositif électrique (150) sur lequel l'organe de plaquage (100, 100') exerce un effort, ladite portion (102) en forme de plaque comprenant au moins une première ouverture traversante (121), l'organe de plaquage (100, 100') étant **caractérisé en ce que** es bords de la première ouverture traversante (121) sont intégralement formés par la dite pluralité de lames ressort (110).

2. Organe de plaquage (100, 100') selon la revendication 1, dans lequel les lames ressort (110) sont formées par une succession d'arc concaves (114) et convexes (113), notamment définis dans ladite portion (102) en forme de plaque.

3. Organe de plaquage (100, 100') selon la revendication 1 ou 2, dans lequel les deuxièmes extrémités (112) des lames ressort (110) définissent une zone libre centrale (121a) autour de laquelle elles sont régulièrement réparties.

4. Organe de plaquage (100, 100') selon l'une des revendications précédentes, comprenant une pluralité de ladite première ouverture traversante (121), dont les bords de chacune sont intégralement formés par une pluralité de lames ressort (110).

5. Organe de plaquage (100, 100') selon l'une des revendications précédentes, comprenant au moins une seconde ouverture traversante (122), dont les bords comprennent des lames ressort (116).

6. Organe de plaquage (100, 100') selon les revendications 4 et 5, dans lequel ladite au moins une seconde ouverture traversante (122) est située dans la portion (102) en forme de plaque entre lesdites premières ouvertures (121).

7. Organe de plaquage (100, 100') selon la revendication précédente, dans lequel les premières ouvertures (121) sont agencées de sorte à être aux sommets d'un quadrilatère, l'au moins une deuxième ouverture (122) étant située dans une zone médiane dudit quadrilatère.

8. Ensemble (200) comprenant un dispositif électrique (150) et au moins un organe de plaquage (100, 100') selon l'une des revendications précédentes, ensemble (200) dans lequel :
- ledit dispositif électrique (150) comprend au moins un composant électronique (152,154) et au moins un conducteur électrique (160p, 160n) fixé sur ledit composant électronique (152,154) pour le connecter électriquement, ledit composant électronique (152,154) et ledit conducteur électrique (160p, 160n) étant connectés l'un à l'autre au niveau d'une zone, dite zone de fixation,
- l'organe de plaquage (100, 100') est configuré pour plaquer ledit dispositif électrique (150) contre une surface, en venant contre une face (F), dite face de plaquage, dudit dispositif électrique (150) comprenant ladite zone de fixation, ladite zone de fixation venant dans la première ouverture de l'organe de plaquage (100, 100') lors du plaquage dudit dispositif électrique (150) par l'organe de plaquage (100, 100').

9. Ensemble (200) selon la revendication 8, comprenant un organe de plaquage (100, 100') selon les revendications 4 et 6, et dans lequel :
- ladite face de plaquage (F) comprend deux zones de fixation à distance l'une de l'autre
- l'organe de plaquage (100, 100') comprend deux premières ouvertures à distance l'une de l'autre de manière à entourer chacune une zone de fixation, la seconde ouverture traversante étant située à équidistance entre lesdites premières ouvertures.

10. Ensemble (200) selon la revendication 8 ou 9, dans lequel la face de plaquage (F) dudit dispositif électrique (150) comprend une polarité positive et une polarité négative dudit dispositif électrique (150).

11. Ensemble (200) selon l'une des revendications 9 à 10, dans lequel au moins une feuille d'isolation électrique est intercalée entre l'organe de plaquage (100') et la face de plaquage (F).

12. Ensemble (200) selon les revendications 10 et 11, dans lequel ledit dispositif électrique (150) comporte :
- au moins deux composants électroniques (152, 154) tels qu'une première partie de la face de plaquage (F) comprend une borne positive (152p) d'un premier composant électronique (152) et une deuxième partie de la face de plaquage (F) comprend une borne négative (154n) d'un deuxième composant électronique (154),
- un premier conducteur électrique (160p), connecté à la borne positive (152p) du premier composant électronique (152) et un deuxième conducteur électrique (160n) connecté à la borne négative (154n) du deuxième composant électronique (154), le premier (160p) et le deuxième (160n) conducteur électrique comportant chacun un bras s'étendant entre le premier (152) et le deuxième (154) composant électronique pour se connecter respectivement à une borne positive du deuxième composant électronique (154) et à une borne négative du premier composant électronique (152), lesdits bras étant agencés l'un à côté de l'autre
l'ensemble (200) comprenant une première feuille d'isolation électrique (170p) intercalée entre l'organe de plaquage (100, 100') et la première partie de la face de plaquage (F) et une deuxième feuille d'isolation électrique (170n) intercalée entre l'organe de plaquage (100, 100') et la deuxième partie de la face de plaquage (F), la première (170p) et la deuxième (170n) feuille d'isolation électrique s'étendant respectivement le long du bras (20) du deuxième conducteur électrique (160n) et du bras du premier conducteur électrique (160p).de manière à isoler électriquement les conducteurs électriques (160p, 160n) entre eux.

13. Ensemble (200) selon la revendication 10, comprenant deux organes de plaquage (100) selon l'une des revendications 1 à 7, chaque organe de plaquage (100) étant directement en contact avec une polarité respective, lesdits organes de plaquage (100) étant isolés électriquement l'un de l'autre.

14. Equipement électrique (300) comprenant un châssis (310) et un ensemble (200) selon l'une des revendications 8 à 13, dans lequel ledit organe de plaquage (100, 100') est pris en compression entre une surface (310a) dudit châssis (310) et le dispositif électrique (150), de manière à plaquer le dispositif électrique (150) contre un circuit de refroidissement (312) de l'équipement électrique.

## Patentansprüche

1. Presselement (100, 100') zum Pressen einer elektrischen Vorrichtung (150) gegen eine Oberfläche, wobei das Presselement (100, 100') einen plattenförmigen Abschnitt (102) und eine Vielzahl von Federblättern (110) beinhaltet, wobei jedes Federblatt (110) ein erstes Ende (111), das mit dem plattenförmigen Abschnitt (102) einstückig ausgebildet ist, und ein zweites Ende (112), das in Bezug auf das erste Ende (111) distal angeordnet ist, aufweist, wobei das zweite Ende (112) dazu bestimmt ist, an der elektrischen Vorrichtung (150), auf die das Presselement (100, 100') eine Kraft ausübt, zur Anlage zu kommen, wobei der plattenförmige Abschnitt (102) mindestens eine erste Durchgangsöffnung (121) beinhaltet, wobei das Presselement (100, 100') **dadurch gekennzeichnet ist, dass** die Ränder der ersten Durchgangsöffnung (121) vollständig durch die Vielzahl von Federblättern (110) gebildet sind.

2. Presselement (100, 100') nach Anspruch 1, wobei die Federblätter (110) aus einer Folge von konkaven (114) und konvexen (113) Bögen gebildet sind, die insbesondere in dem plattenförmigen Abschnitt (102) definiert sind.

3. Presselement (100, 100') nach Anspruch 1 oder 2, wobei die zweiten Enden (112) der Federblätter (110) einen mittigen freien Bereich (121a) definieren, um den herum sie regelmäßig verteilt sind.

4. Presselement (100, 100') nach einem der vorhergehenden Ansprüche, das eine Vielzahl der ersten Durchgangsöffnung (121) beinhaltet, deren Ränder jeweils vollständig durch eine Vielzahl von Federblättern (110) gebildet sind.

5. Presselement (100, 100') nach einem der vorhergehenden Ansprüche, das mindestens eine zweite Durchgangsöffnung (122) beinhaltet, deren Ränder Federblätter (116) beinhalten.

6. Presselement (100, 100') nach den Ansprüchen 4 und 5, wobei sich die mindestens eine zweite Durchgangsöffnung (122) in dem plattenförmigen Abschnitt (102) zwischen den ersten Öffnungen (121) befindet.

7. Presselement (100, 100') nach dem vorhergehenden Anspruch, wobei die ersten Öffnungen (121) so angeordnet sind, dass sie sich in den Spitzen eines Vierecks befinden, wobei sich die mindestens eine zweite Öffnung (122) in einem mittleren Bereich des Vierecks befindet.

8. Anordnung (200), die eine elektrische Vorrichtung (150) und mindestens ein Presselement (100, 100') nach einem der vorhergehenden Ansprüche beinhaltet, wobei in der Anordnung (200):
- die elektrische Vorrichtung (150) mindestens eine elektronische Komponente (152, 154) und mindestens einen elektrischen Leiter (160p, 160n), der an der elektronischen Komponente (152, 154) befestigt ist, um diese elektrisch zu verbinden, beinhaltet, wobei die elektronische Komponente (152, 154) und der elektrische Leiter (160p, 160n) in einem Bereich, der als Befestigungsbereich bezeichnet wird, miteinander verbunden sind,
- das Presselement (100, 100') dazu konfiguriert ist, die elektrische Vorrichtung (150) gegen eine Oberfläche zu pressen, indem es gegen eine Fläche (F), die als Pressfläche bezeichnet wird, der elektrischen Vorrichtung (150) drückt, die den Befestigungsbereich beinhaltet,
wobei der Befestigungsbereich beim Pressen der elektrischen Vorrichtung (150) durch das Presselement (100, 100') in der ersten Öffnung des Presselements (100, 100') zu liegen kommt.

9. Anordnung (200) nach Anspruch 8, die ein Presselement (100, 100') nach den Ansprüchen 4 und 6 beinhaltet, und wobei:
- die Pressfläche (F) zwei voneinander beabstandete Befestigungsbereiche beinhaltet,
- das Presselement (100, 100') zwei voneinander beabstandete erste Öffnungen beinhaltet, sodass sie jeweils einen Befestigungsbereich umgeben, wobei sich die zweite Durchgangsöffnung gleich weit entfernt zwischen den ersten Öffnungen befindet.

10. Anordnung (200) nach Anspruch 8 oder 9, wobei die Pressfläche (F) der elektrischen Vorrichtung (150) eine positive Polarität und eine negative Polarität der elektrischen Vorrichtung (150) beinhaltet.

11. Anordnung (200) nach einem der Ansprüche 9 bis 10, wobei mindestens eine elektrische Isolationsfolie zwischen das Presselement (100') und die Pressfläche (F) eingefügt ist.

12. Anordnung (200) nach den Ansprüchen 10 und 11, wobei die elektrische Vorrichtung (150) Folgendes umfasst:
- mindestens zwei elektronische Komponenten (152, 154), sodass ein erster Teil der Pressfläche (F) eine positive Klemme (152p) einer ersten elektronischen Komponente (152) beinhaltet und ein zweiter Teil der Pressfläche (F) eine negative Klemme (154n) einer zweiten elektronischen Komponente (154) beinhaltet,
- einen ersten elektrischen Leiter (160p), der mit der positiven Klemme (152p) der ersten elektronischen Komponente (152) verbunden ist, und einen zweiten elektrischen Leiter (160n), der mit der negativen Klemme (154n) der zweiten elektronischen Komponente (154) verbunden ist, wobei der erste (160p) und der zweite (160n) elektrische Leiter jeweils einen Arm umfassen, der sich zwischen der ersten (152) und der zweiten (154) elektronischen Komponente erstreckt, um sich mit einer positiven Klemme der zweiten elektronischen Komponenten (154) bzw. mit einer negativen Klemme der ersten elektronischen Komponente (152) zu verbinden, wobei die Arme nebeneinander angeordnet sind,
wobei die Anordnung (200) eine erste elektrische Isolationsfolie (170p), die zwischen das Presselement (100, 100') und den ersten Teil der Pressfläche (F) eingefügt ist, und eine zweite elektrische Isolationsfolie (170n), die zwischen das Presselement (100, 100') und den zweiten Teil der Pressfläche (F) eingefügt ist, beinhaltet, wobei sich die erste (170p) und die zweite (170n) elektrische Isolationsfolie entlang des Arms (20) des zweiten elektrischen Leiters (160n) bzw. des Arms des ersten elektrischen Leiters (160p) erstrecken, um die elektrischen Leiter (160p, 160n) elektrisch voneinander zu isolieren.

13. Anordnung (200) nach Anspruch 10, die zwei Presselemente (100) nach einem der Ansprüche 1 bis 7 beinhaltet, wobei jedes Presselement (100) direkt mit einer jeweiligen Polarität in Kontakt ist, wobei die Presselemente (100) elektrisch voneinander isoliert sind.

14. Elektrische Ausrüstung (300), die ein Gestell (310) und eine Anordnung (200) nach einem der Ansprüche 8 bis 13 beinhaltet, wobei das Presselement (100, 100') zwischen einer Oberfläche (310a) des Gestells (310) und der elektrischen Vorrichtung (150) eingeklemmt ist, um die elektrische Vorrichtung (150) gegen einen Kühlkreis (312) der elektrischen Ausrüstung zu pressen.

## Claims

1. Pressing member (100, 100') for pressing an electrical device (150) against a surface, the pressing member (100, 100') comprising a portion (102) in the form of a plate and a plurality of spring leaves (110), each spring leaf (110) having a first end (111) integral with the portion (102) in the form of a plate and a second distal end (112) with respect to the first end (111), said second end (112) being intended to bear against the electrical device (150) on which the pressing member (100, 100') exerts a force, said portion (102) in the form of a plate comprising at least one first through-opening (121), the pressing member (100, 100') being **characterized in that** the edges of the first through-opening (121) are entirely formed by said plurality of spring leaves (110).

2. Pressing member (100, 100') according to Claim 1, wherein the spring leaves (110) are formed by a succession of concave (114) and convex (113) arcs, in particular defined in said portion (102) in the form of a plate.

3. Pressing member (100, 100') according to Claim 1 or 2, wherein the second ends (112) of the spring leaves (110) define a central free region (121a) about which they are regularly distributed.

4. Pressing member (100, 100') according to one of the preceding claims, comprising a plurality of said first through-openings (121), the edges of each of which are entirely formed by a plurality of spring leaves (110).

5. Pressing member (100, 100') according to one of the preceding claims, comprising at least one second through-opening (122), the edges of which comprise spring leaves (116).

6. Pressing member (100, 100') according to Claims 4 and 5, wherein said at least one second through-opening (122) is situated in the portion (102) in the form of a plate between said first openings (121) .

7. Pressing member (100, 100') according to the preceding claim, wherein the first openings (121) are arranged so as to be at the apexes of a quadrilateral, the at least one second opening (122) being situated in a median region of said quadrilateral.

8. Assembly (200) comprising an electrical device (150) and at least one pressing member (100, 100') according to one of the preceding claims, in which assembly (200):
- said electrical device (150) comprises at least one electronic component (152, 154) and at least one electrical conductor (160p, 160n) fastened to said electronic component (152, 154) in order to connect it electrically, said electronic component (152, 154) and said electrical conductor (160p, 160n) being connected to one another at a region, termed fastening region,
- the pressing member (100, 100') is configured to press said electrical device (150) against a surface, coming against a face (F), termed pressing face, of said electrical device (150) comprising said fastening region, said fastening region coming into the first opening of the pressing member (100, 100') during the pressing of said electrical device (150) by the pressing member (100, 100').

9. Assembly (200) according to Claim 8, comprising a pressing member (100, 100') according to Claims 4 and 6, and wherein:
- said pressing face (F) comprises two fastening regions at a distance from one another,
- the pressing member (100, 100') comprises two first openings at a distance from one another so as to each surround a fastening region, the second through-opening being situated equidistantly between said first openings.

10. Assembly (200) according to Claim 8 or 9, wherein the pressing face (F) of said electrical device (150) comprises a positive polarity and a negative polarity of said electrical device (150).

11. Assembly (200) according to either of Claims 9 and 10, wherein at least one electrical insulation sheet is interposed between the pressing member (100') and the pressing face (F).

12. Assembly (200) according to Claims 10 and 11, wherein said electrical device (150) comprises:
- at least two electronic components (152, 154) such that a first part of the pressing face (F) comprises a positive terminal (152p) of a first electronic component (152) and a second part of the pressing face (F) comprises a negative terminal (154n) of a second electronic component (154),
- a first electrical conductor (160p) connected to the positive terminal (152p) of the first electronic component (152) and a second electrical conductor (160n) connected to the negative terminal (154n) of the second electronic component (154), the first (160p) and the second (160n) electrical conductor each comprising an arm extended between the first (152) and the second (154) electronic component in order to be respectively connected to a positive terminal of the second electronic component (154) and to a negative terminal of the first electronic component (152), said arms being arranged one beside the other,
the assembly (200) comprising a first electrical insulation sheet (170p) interposed between the pressing member (100, 100') and the first part of the pressing face (F) and a second electrical insulation sheet (170n) interposed between the pressing member (100, 100') and the second part of the pressing face (F), the first (170p) and the second (170n) electrical insulation sheet respectively extending along the arm (20) of the second electrical conductor (160n) and along the arm of the first electrical conductor (160p) so as to electrically insulate the electrical conductors (160p, 160n) from one another.

13. Assembly (200) according to Claim 10, comprising two pressing members (100) according to one of Claims 1 to 7, each pressing member (100) being directly in contact with a respective polarity, said pressing members (100) being electrically insulated from one another.

14. Electrical equipment item (300) comprising a chassis (310) and an assembly (200) according to one of Claims 8 to 13, wherein said pressing member (100, 100') is compressed between a surface (310a) of said chassis (310) and the electrical device (150) so as to press the electrical device (150) against a cooling circuit (312) of the electrical equipment item.
